Europäisches Patentamt

European Patent Office

Office européen des brevets

(19)

(11) Publication number: **0 195 607**
**B1**

# EUROPEAN PATENT SPECIFICATION

(12)

(45) Date of publication of the patent specification:
**27.12.89**

(51) Int. Cl.⁴: **H01L 29/08**

(21) Application number: **86301835.4**

(22) Date of filing: **13.03.86**

(54) **Semiconductor device.**

(30) Priority: **20.03.85 JP 57416/85**

(43) Date of publication of application:
**24.09.86 Bulletin 86/39**

(45) Publication of the grant of the patent:
**27.12.89 Bulletin 89/52**

(84) Designated Contracting States:
**DE FR GB**

(56) References cited:
**US-A- 4 172 260**

**IEEE TRANSACTIONS ON ELECTRON DEVICES, vol.
ED-29, no. 4, April 1982, pages 590-596, IEEE, New York,
US; P.J. TSANG et al.: "Fabrication of high-performance
LDDFET's with oxide sidewall-spacer technology"
IEEE TRANSACTIONS ON ELECTRON DEVICES, vol.
ED-30, no. 6, June 1983, pages 652-657, IEEE, New York,
US; E. TAKEDA et al.: "An As-P(n+-n-) double diffused
drain MOSFET for VLSI's"
IEEE TRANSACTIONS ON ELECTRON DEVICES, vol.
ED-32, no. 3, March 1985, pages 562-570, IEEE, New
York, US; M. KOYANAGI et al.: "Optimum design of
n+-n- double-diffused drain MOSFET to reduce
hot-carrier emission"
PATENTS ABSTRACTS OF JAPAN, vol. 10,**

(73) Proprietor: **FUJITSU LIMITED, 1015, Kamikodanaka
Nakahara-ku, Kawasaki-shi Kanagawa 211(JP)**

(72) Inventor: **Yoshida, Toshihiko, A 201, Kopo
Narushisu, 2-7-7 Shinishikawa, Midori-ku Yokohama-shi
Kanagawa 227(JP)**
Inventor: **Inaba, Toru, 539-50, Kamikashio, Totsuka-ku
Yokohama-shi Kanagawa 244(JP)**

(74) Representative: **Rackham, Stephen Neil et al, GILL
JENNINGS & EVERY 53-64 Chancery Lane, London
WC2A 1HN(GB)**

(56) References cited: (continuation)
**no. 42 (E-382)[2099], 19th February 1986; & JP - A
- 60 198 780 (SEIKO DENSHI KOGYO K.K.) 08-10-1985
PATENTS ABSTRACTS OF JAPAN, vol. 10,
no. 91 (E-394)[2148], 9th April 1986; & JP - A
- 60 234 367 (HITACHI SEISAKUSHO K.K.) 21-11-1985
PATENTS ABSTRACTS OF JAPAN, vol. 9,
no. 298 (E-361)[2021], 26th November 1985; & JP - A
- 60 136 376 (HITACHI SEISAKUSHO
K.K.) 19-07-1985 (Cat. D,P,X)
.IDEM**

## Description

This invention relates to a semiconductor device, and more particularly to a semiconductor device wherein source and drain regions having three regions formed by three different types of impurity doping steps are formed to prevent the occurrence of hot electrons which otherwise cause deterioration of the performance of the device.

With the miniaturisation of semiconductor devices, the length of the gate electrode of a MIS FET has been shortened. The supply voltage is generally maintained at 5 V, and there is no tendency to lower this voltage. Hence, particularly in an n-channel MIS transistor, the drain electric field is larger than in a conventional device, and some of the electrons accelerated by the increased electric field are injected into the gate insulating film. This is well known as a channel hot-electron phenomenon. Furthermore, some of the electrons generated by the impact ionisation are injected into the gate insulating film and change the characteristic of the MIS transistor. This is well known as an avalanche hot-electron phenomomen.

In order to solve the problem of the hot electron phenomena, a double diffused drain (DDD) structure and a lightly doped drain (LDD) structure have been proposed, in which the electric field is not concentrated in the DDD structure, and the hot electron phenomenon is therefore reduced. However, in the DDD structure the effective channel length is decreased and a punch-through phenomenon is therefore generated. Furthermore, problems of deterioration in the mutual conductance ($g_m$) and in the breakdown voltage arise.

On the other hand, although the LDD structure has an effect on the channel hot-electron phenomenon, it has little effect on the avalanche hot-electron phenomenon in which electrons generated at a deeper portion of the substrate due to the high electric field strength are accelerated so that the electrons are moved to the gate electrode through the gate insulating film. In addition, in the LDD structure deterioration of the mutual conductance also occurs.

Accordingly, an object of the present invention is to provide a semiconductor device, particularly a MIS FET, wherein channel hot-electron and avalanche hot-electron phenomena are decreased.

Another object of the present invention is to provide a semiconductor device wherein the mutual conductance ($g_m$) thereof is improved.

According to a first aspect of the present invention there is provided a semiconductor device having a gate electrode formed on a semiconductor substrate and source and drain regions formed in the semiconductor substrate, the source and drain regions each comprising:

a shallow first impurity region doped with impurity of opposite conductivity type to that of the semiconductor substrate and extending laterally to the edge of the respective source or drain region adjacent an edge of the gate electrode and having a first junction surface with the semiconductor substrate;

a second impurity region doped with impurity of opposite conductivity type to the semiconductor substrate, the impurity of the second impurity region having a diffusion coefficient larger than that of the impurity of the first impurity region, said second impurity region extending below the first impurity region to a first depth and extending laterally to the edge of the respective source or drain region, the second impurity region having a second junction surface with the said semiconductor substrate at the said edge of the source or drain region the said second junction surface being substantially tangential to the first junction surface at the edge of the respective source or drain region adjacent the edge of the gate electrode; and

a third impurity region doped with impurity of opposite conductivity type to the semiconductor substrate, the impurity of the third impurity region having a diffusion coefficient smaller than that of the impurity of the second impurity region, the third impurity region extending laterally to a region laterally spaced from the said edge of the respective source or drain region and extending to a second depth less than the said first depth of the second impurity region, the third impurity region having a higher concentration than that of the first and second impurity regions.

According to a second aspect of the present invention a method of manufacturing a semiconductor device having a gate electrode formed on a semiconductor substrate and source and drain regions formed in the semiconductor substrate comprises:

doping each of the source or drain regions with impurity of opposite conductivity type to that of the semiconductor substrate forming a shallow first impurity region extending laterally to the edge of the respective source or drain region adjacent an edge of the gate and having a first junction surface with the semiconductor substrate;

doping each of the source or drain regions with impurity of opposite conductivity type to that of the semiconductor substrate and having a diffusion coefficient larger than that of the impurity of the first impurity region forming a second impurity region extending below the first impurity region to a first depth, extending laterally to the edge of the respective source or drain region, and having a second junction surface with the semiconductor substrate at the edge of the source or drain region, the said second junction surface being substantially tangential to the first junction surface at the edge of the respective source or drain region; and

doping each of the source or drain regions with impurity of opposite conductivity type to the said semiconductor substrate and a diffusion coefficient smaller than that of the impurity of the second impurity region at a concentration higher than that of the first and second impurity regions forming a third impurity region extending laterally to a region lagerally spaced from the said edge of the respective source or drain region and extending to a second depth less than the said first depth of the second impurity region.

Embodiments of the invention will now be described, by way of example, with reference to the accompanying drawings, in which:

Figure 1A is a cross-sectional view of an example of a conventional DDD structure;

Figure 1B is an equivalent circuit of the structure of Figure 1A;

Figures 2, 3 and 4 are cross-sectional views of respective examples of conventional LDD structures;

Figure 5A is a cross-sectional view of an example of an n-channel MIS FET according to the present invention;

Figure 5B is an equivalent circuit of the MIS FET of Figure 5A; and

Figures 6A to 6D and Figures 7A to 7D are cross-sectional views for explaining two production processes for forming devices according to the invention.

Before describing a preferred embodiment of the present invention, the related art will be explained in more detail with reference to the drawings.

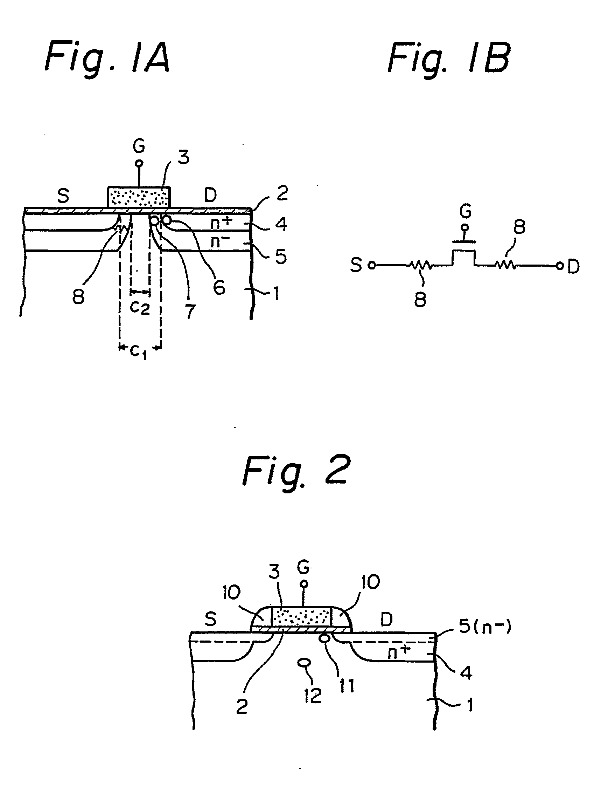

Figure 1A is a cross-sectional view of a conventional example of a DDD structure, wherein an insulating film 2 and a gate electrode 3 are provided on a p-type semiconductor substrate 1. In the substrate 1 an $n^+$ region 4 and an $n^-$ region 5 are formed by doping, for example, arsenic ions ($As^+$) and phosphorus ions ($P^+$), followed by annealing. Since the diffusion coefficient of phosphorus is considerably larger than that of arsenic, a double diffused drain (DDD) region, i.e. an $n^+$ region ($As^+$) and an $n^-$ region ($P^+$), is formed. The structure formed before the DDD structure was formed had only the $n^+$ region 4, wherein $As^+$ was diffused, so that a step-junction was formed. Hence, in the prior structure, an electric field concentrated at a portion 6 in the $n^+$ region 4 where the step-junction was formed, and this led to the problem of the occurrence of the hot-electron phenomenon as mentioned above.

Therefore, by forming the above mentioned $n^-$ region ($P^+$) 5 of the DDD structure, in such a manner that the $n^-$ region ($P^+$) 5 covers the $n^+$ region 4, a graded junction formed by the diffusion of a $P^+$ electric field is shifted to a portion 7 in the $n^-$ region. Consequently, the concentration of an electric field in the portion 7 is considerably decreased compared to that in the portion 6.

However, the DDD structure has an effective channel length (C2) shorter than that (C1) of a prior structure not having an $n^-$ region, as shown in Figure 1A. Consequently, in the DDD structure a punch-through phenomen often occurs between the source and drain region. Further, in the DDD structure, the properties of the FET are determined by the concentration of $P^+$ in the $n^-$ type region 5. If the concentration of $P^+$ is low, parasitic series resistance is generated, as shown by reference 8 in Figure 1A.

An equivalent circuit of the device of Figure 1A is shown in Figure 1B. Thus, it can be seen that if the concentration of $P^+$ is low, the mutual conductance ($g_m$) of the device cannot be increased. On the other hand, if the concentration of $P^+$ is high, the breakdown voltage is lowered.

Referring to Figure 2, a lightly-doped drain (LDD) structure is shown in which a gate insulating film 2, a gate electrode 3, and a side wall 10 are formed on a p-type semiconductor substrate 1. In the substrate 1 an $n^-$ region 5 and an $n^+$ region 4 formed by doping $As^+$ and subsequent annealing are provided. In the formation process of the $n^-$ and $n^+$ regions, $As^+$ having a low concentration is doped into the substrate 1 to forme the $n^-$ region 5, and $As^+$ having a high concentration is doped therein to form an $n^+$ region 4. Since the diffusion depth ($x_j$) of the doped impurities is determined by the root of the concentration (C) thereof, i.e. $x_j \alpha \sqrt{C}$, an LDD structure as shown in Figure 2 is obtained. The LDD structure can prevent occurrence of channel hot electrons at a portion 11 in Figure 2. However, the LDD structure cannot prevent the occurrence of avalanche hot electrons which are generated at a deeper portion 12 of the substrate 1 due to the high electric field strength, and accelerated to move into the gate electrode 3 through the gage insulating film 2. Furthermore, deterioration of the mutual conductance ($g_m$) occurs as in the DDD structure.

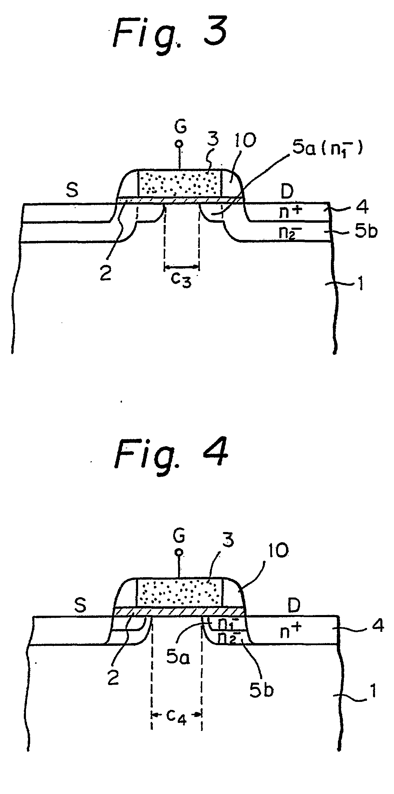

Figure 3 shows a semiconductor device as disclosed in Japanese Unexamined Patent Publication (Kokai) No. 60-136 376, published 19.07.1985. This device (Hitachi structure) has an $n^+$ region 4, an $n_1^-$ region 5a and an $n_2^-$ region 5b in the source and drain regions. Each region is produced by a process wherein $P^+$ is doped to a dosage of $1 \times 10^{12}$ $cm^{-2}$ using a polycrystalline layer of a gate electroce 3 formed on a gate insulating film 2 as a mask, side walls of $SiO_2$ are formed so that the gate electrode 3 is sandwiched therebetween, $P^+$ doped to a dosage of $1 \times 10^{14}$ $cm^{-2}$ using the gate electrode 3 and the side walls 10 as a mask, $P^+$ is doped portions are annealed while the doped $P^+$ is diffused so that the $n_1^-$ region 5a ($P^+$ doped to a dosage of $1 \times 10^{12}$ $cm^{-2}$) and $n_2^-$ region 5b ($P^+$ doped to a dosage of $1 \times 10^{12}$ $cm^{-2}$) and $n_2^-$ region 5b ($P^+$ doped to a dosage $1 \times 10^{14}$ $cm^{-2}$) are formed, $As^+$ is doped to a dosage of $5 \times 10^{15}$ $cm^{-2}$ using the gate electrode 3 and the side walls 10 as a mask, and the $n^+$ region 4 is formed by annealing the $As^+$ doped portion.

Since the $n_1^-$ region 5a is formed by doping $P^+$, which has a large diffusion coefficient, into the substrate 1, the distance C3 between the edges of the $n_1^-$ regions 5a, i.e. the channel length, becomes short and the above-mentioned punch-through phenomenon occurs. Further, as explained for the DDD structure, the Hitachi structure is subjected to a resistance due to the diffused $n_1^-$ region 5a, so that the mutual conductance ($g_m$) is lowered. These disadvantages in the Hitachi structure become greater as the semiconductor device becomes smaller.

Figure 4 shows a semiconductor device disclosed at a Symposium on VLSI Technology, 14 to 16 May, 1985. This device (Toshiba structure) also has three regions, i.e. $n_1^-$, $n_2^-$, and $n^+$ regions.

Each region is produced by a process wherein $P^+$

and As+ are doped using a gate electrode 3 as a mask, and P+ and As+ doped portions are annealed to form the $n_2^-$ region 5b and $n_1^-$ region 5a, respectively, side walls 10 are formed, As+ is doped using the gate electrode 3 and the side walls 10 as a mask, and the second As+ doped portion is annealed to form the n+ region 4. Since the $n_2^-$ region is formed by annealing the P+ doped portion, as explained for the Hitachi structure, the Toshiba structure also has the disadvantage of the occurrence of a punch-through phenomenon, and the mutual conductance ($g_m$) becomes small.

Preferred embodiments of the present invention will now be described.

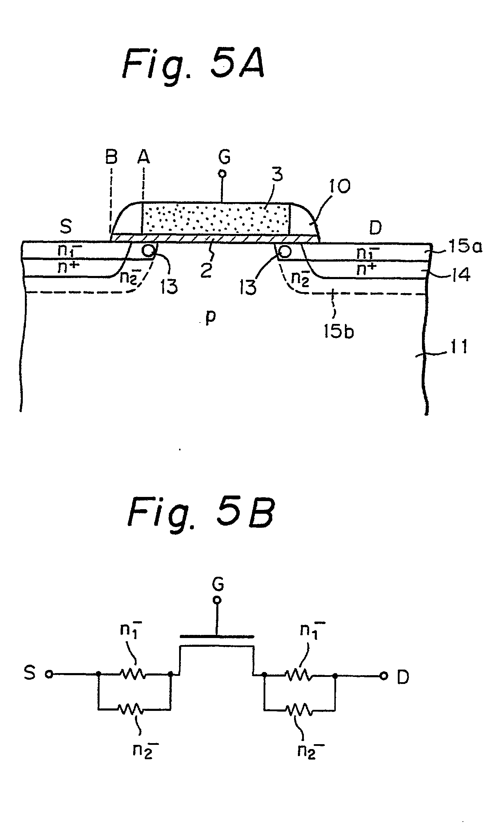

Figure 5A shows a cross-sectional view for explaining an example of an n-channel MIS FET according to the invention. As shown in Figure 5A, a source (S) region and a drain (D) region in a P-type semiconductor substrate or p-type well 11 each consist of an $n_1^-$ region 15a, an $n_2^-$ region 15b, and an n+ region 14. An insulating film 2 of, for example, $SiO_2$, a gate electrode 3 of polycristalline silicon, and side walls 10 of an insulating material are provided on the semiconductor substrate 11. The $n_1^-$ region 15a is formed by doping impurities having a low concentration from outside the edge A of the gate electrode 3.

On the other hand, the $n_2^-$ region 15b and the n+ region 14 are formed by doping impurities having a low and a high concentration, respectively, from outside the edges B of the side walls 10. The diffusion coefficient of impurities doped in the $n_2^-$ region is larger than that of impurities doped in the $n_1^-$ and n+ regions. Although the electric field is concentrated in portions 13 lying in both the $n_1^-$ region 15a and the $n_2^-$ region 15b, the electric field concentration is reduced due to the graded junction of the $n_2^-$ region. This gives an improvement in the deterioration of the properties by two orders, compared with the previous example wherein the hot-electron phenomenon could not be avoided. Furthermore, since the $n_2^-$ region has a graded junction, the depletion layer is expanded and thus the stray capacitance of the source and drain regions is reduced and the switching speed of the device can be increased.

Resistance in the structure is shown in Figure 5B. Namely, the resistance in, for example, the source region, which is generated by the $n_1^-$ and $n_2^-$ regions, is the total resistance in the $n_1^-$ and $n_2^-$ regions connected in parallel with each other (not in series) and is reduced, thus allowing an increase in the mutual conductance ($g_m$).

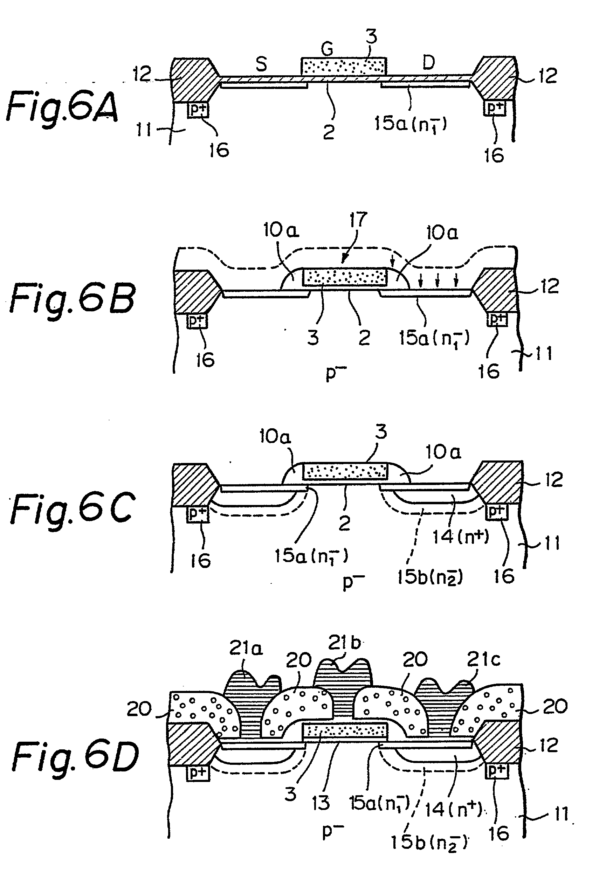

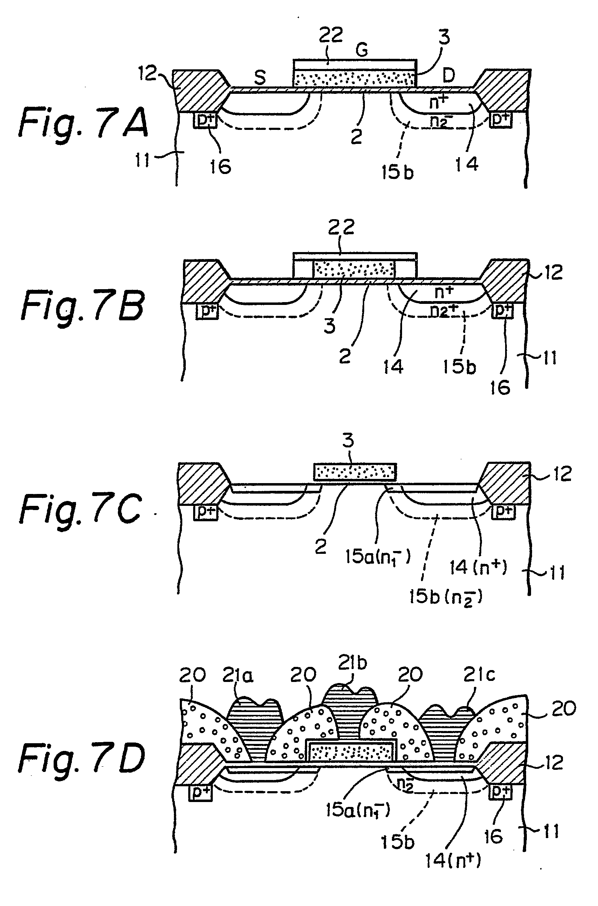

Process for producing an embodiment of the invention will now be described with reference to Figures 6A to 6D and Figures 7A to 7D respectively.

As shown in Figure 6A, p-type channel cut regions 16, a field insulating film 12 of, for example, $SiO_2$, and a gate insulating film 2 of, for example, $SiO_2$, are formed on a p-type semiconductor substrate 11 which has an impurity concentration of $10^{15} - 10^{16}$ cm$^{-3}$, and then a gate electrode 3 having a thickness of $2 \times 10^{-7}$ to $5 \times 10^{-7}$m (2000 to 5000 A°) is formed. The gate electrode 3 is made of polycristalline silicon, a high melting point metal or a high melting point metalsilicide, etc. Then, As+ is doped to a dosage of $1 \times 10^{13}$ to $1 \times 10^{15}$ cm$^{-2}$ at an accelerating energy of 60 to 120 KeV, so that the first lightly-doped $n_1^-$ regions, i.e. $n_1^-$ regions 15a are formed.

Then, as shown in Figure 6B, an insulating layer 17 having a thickness of $5 \times 10^{-8}$ to $5 \times 10^{-7}$ (500 to 5000 Å) is formed on the obtained structure. Then insulating layer is made of $SiO_2$ or $Si_3N_4$ formed by a chemical vapour deposition (CVD) process, etc.

Then, the insulating layer 17 of, for example, CVD–$SiO_2$, is entirely removed by a reactive ion etching (RIE) process using $CHF_3$ gas or a mixed gaf of $CHF_3$ and $CF_4$ under a pressure of $1.3 \times 10$ to $2.6 \times 10$ Pa (0.1 to 0.2 torr) so that side walls 10a are formed in such a manner that they sandwich the gate electrode 3.

Then, as shown in Figure 6C, P+ having a larger diffusion coefficient than the As+ is doped to a dosage of $1 \times 10^{13}$ to $1 \times 10^{15}$ cm$^{-2}$ at an accelerating energy of 60 to 80 KeV to form a second lightly-doped n$^-$ region, i.e. the $n_2^-$ region 15b, and As+ is doped to a dosage of $3 \times 10^{15}$ to $5 \times 10^{15}$cm$^{-2}$ at an accelerating energy or 60 to 120 KeV to form a heavily-doped or high-concentration n+ region 14. The obtained structure is then annealed at a temperature of 900°C to 1100°C in an inert gas atmosphere.

The $n_2^-$ region has a graded junction formed between the $n_2^-$ region and the substrate 1. The graded junction surface formed between the $n_2^-$ region 15b and the substrate 11 forms a surface substantially tangential to a junction surface formed between the $n_1^-$ region 15a and the substrate 11.

Then, as shown in Figure 6D, an insulating layer 20 of, for example, phospho-silicate glass (PSG), boron silicate glass (BSG), etc. is formed, and an aluminium source drawing electrode 21a, an aluminium gate drawing electrode 21b, and an aluminium drain drawing electrode 21C are formed by a usual process. In this manner, a first embodiment of the present invention is produced.

A process for producing a second embodiment of the present invention will now be described. As shown in Figure 7A p-type channel cut regions 16, a field insulating film 2 and a gate insulating film 2 are formed on a p-type semiconductor substrate 11. A gate electrode 3 having a thickness of $2 \times 10^{-7}$ to $5 \times 10^{-7}$m (2000 to 5000Å) and a width longer than the width of the gate electrode in the first embodiment described above is then formed, using a mask 22 of CVD $SiO_2$ having a thickness of $5 \times 10^{-8}$ to $2 \times 10^{-7}$m (500 to 2000 Å). The material of the gate electrode is the same as that used in the first embodiment. P+ is then doped to a dosage of $1 \times 10^{13}$ to $1 \times 10^{15}$ cm$^{-2}$ at an accelerating energy of 60 to 80 KeV to form a light-doped $n_2^-$ region 15b. Then As+ is doped to a dosage of $3 \times 10^{15}$ to $5 \times 10^{15}$ cm$^{-2}$ at an accelerating energy of 60 to 120 KeV to form a heavily-doped or high concentration n+ region 14.

Then, as shown in Figure 7B, both sides of the gate electrode 3 are removed by a side plasma etching process using a mixed gas of $CF_4$ and $O_2$ (5%) in a polycristalline silicon gate electrode so that a width of $1 \times 10^{-7}$ to $4 \times 10^{-7}$m (1000 to 4000 Å) is removed frcm each side thereof.

Then, as shown in Figure 7C, the mask 22 of CVD SiO$_2$ is removed and As$^+$ is doped to a dosage of $1 \times 10^{13}$ to $1 \times 10^{15}$ cm$^{-2}$ at an accelerating energy of 60 to 120 KeV to form a lightly-doped n$_1^-$ region 15a. An annealing process is then carried out at a temperature of 900°C to 1100°C in an inert gas atmosphere.

Then, as shown in Figure 7D, an insulating layer 20 and aluminium electrodes 21a, 21b, and 21c are formed as described in the first embodiment. A second embodiment of the invention is thereby produced.

**Claims**

1. A semiconductor device having a gate electrode formed on a semiconductor substrate (11) and source (S) and drain (D) regions formed in the semiconductor substrate (11), the source (S) and drain (D) regions each comprising:
   a shallow first impurity region (15a) doped with impurity of opposite conductivity type to that of the semiconductor substrate (11) and extending laterally to the edge of the respective source (S) or drain (D) region adjacent an edge (A) of the gate electrode and having a first junction surface with the semiconductor substrate (11);
   a second impurity region (15b) doped with impurity of opposite conductivity type to the semiconductor substrate (11), the impurity of the second impurity region having a diffusion coefficient larger than that of the impurity of the first impurity region, said second impurity region extending below the first impurity region (15a) to a first depth and extending laterally to the edge of the respective source (S) or drain (D) region, the second impurity region (15b) having a second junction surface with the said semiconductor substrate (11) at the said edge of the source (S) or drain region (D), the said second junction surface being substantially tangential to the first junction surface at the edge of the respective source (S) or drain (D) region adjacent the edge of the gate electrode (3); and
   a third impurity region (14) doped with impurity of opposite conductivity type to the semiconductor substrate (11) the impurity of the third impurity region having a diffusion coefficient smaller than that of the impurity of the second impurity region, the third impurity region (14) extending laterally to a region laterally spaced from the said edge of the respective source or drain region and extending to a second depth less than the said first depth of the second impurity region (15b), the third impurity region having a higher concentration than that of the first and second impurity regions.

2. A device according to claim 1, in which the impurity in the first impurity region (15a) is arsenic.

3. A device according to claim 1 oe 2, in which the impurity in the second impurity region (15b) is phosphorus.

4. A device according to any preceding claim, characterized in that the impurity in the third impurity region (14) is arsenic.

5. A device according to any preceding claim, characterised in that the spacing from the edge of the gate electrode (3) is determined by the width of a side wall (10) alongside the gate electrode.

6. A method of manufacturing a semiconductor device having a gate electrode (3) formed on a semiconductor substrate (11) and source (S) and drain (D) regions formed in the semiconductor substrate (11), comprising:
   doping each of the source or drain regions with impurity of opposite conductivity type to that of the semiconductor substrate (11) forming a shallow first impurity region extending laterally to the edge of the respective source (S) or drain (D) region adjacent an edge (A) of the gate and having a first junction surface with the semiconductor substrate (11);
   doping each of the source or drain regions with impurity of opposite conductivity type to that of the semiconductor substrate (11) and having a diffusion coefficient larger than that of the impurity of the first impurity region forming a second impurity region (15b) extending below the first impurity region (15a) to a first depth, extending laterally to the edge of the respective source (S) or drain (D) region and having a second junction surface with the semiconductor substrate (11) at the edge of the source (S) or drain (D) region, the said second junction surface being substantially tangential to the first junction surface at the edge of the respective source (S) or drain (D) region; and
   doping each of the source (S) or drain (D) regions with impurity of opposite conductivity type to the said semiconductor substrate (11) and a diffusion coefficient smaller than that of the impurity of the second impurity region (15b) at a concentration higher than that of the first and second impurity regions (15a, 15b) forming a third impurity region (14) extending laterally to a region laterally spaced from the said edge of the respective source (S) or drain (D) region and extending to a second depth less than the said first depth of the second impurity region (15b).

7. A method according to claim 6, in which in the step of forming the shallow first impurity region (15a) arsenic ions are doped into the semiconductor substrate (11) to a dosage of $1 \times 10^{13}$ to $1 \times 10^{15}$ cm$^{-2}$ and at an accelerating energy of 60 to 120 KeV.

8. A method according to claim 6 or 7, in which in the step of forming the second impurity region (15b) the phosphorus ions are doped into the semiconductor substrate (11) to a dosage of $1 \times 10^{13}$ to $1 \times 10^{15}$ cm$^{-2}$ and at an accelerating energy of 60 to 80 KeV.

9. A device according to any one of claims 6 to 8, in which in the step of forming the third impurity region (14) arsenic ions are doped into the semiconductor substrate (11) to a dosage of $3 \times 10^{15}$ to $5 \times 10^{15}$ cm$^{-2}$ and at an accelerating energy of 60 to 120 KeV.

**Patentansprüche**

1. Halbleitervorrichtung mit einer Gateelektrode, die auf einem Halbleitersubstrat (11) gebildet ist, und Source-(S)- und Drain-(D)-Bereichen, die in dem Halbleitersubstrat (11) gebildet sind, bei der die Source-(S)- und Drain-(D)-Bereiche jeweils umfassen:

einen flachen ersten Verunreinigungsbereich (15a), der mit einer Verunreinigung vom entgegengesetzten Leitfähigkeitstyp zu demjenigen des Halbleitersubstrats (11) dotiert ist und sich seitlich zu dem Rand des jeweiligen Source-(S)- oder Drain-(D)-Bereichs neben einem Rand (A) der Gateelektrode erstreckt und eine erste Grenzfläche mit dem Halbleitersubstrat (11) hat;

einen zweiten Verunreinigungsbereich (15b), der mit einer Verunreinigung vom Leitfähigkeitstyp, der zu dem Leitfähigkeitstyp des Halbleitersubstrats (11) entgegengesetzt ist, dotiert ist, wobei die Verunreinigung des zweiten Verunreinigungsbereichs einen Diffusionskoeffizienten hat, der größer als jener der Verunreinigung des ersten Verunreinigungsbereiches ist, und der genannte zweite Verunreinigungsbereich sich unter den ersten Verunreinigungsbereich (15a) bis zu einer Tiefe erstreckt und sich seitlich zu dem Rand des jeweiligen Source-(S)- oder Drain-(D)-Bereichs erstreckt, wobei der zweite Verunreinigungsbereich (15b) eine zweite Grenzfläche mit dem genannten Halbleitersubstrat (11) an dem genannten Rand des Source-(S)- oder Drain-(D)-Bereichs hat, die genannte zweite Grenzfläche im wesentlichen tangential zu der ersten Grenzfläche an dem Rand des jeweiligen Source-(S)- oder Drain-(D)-Bereichs neben dem Rand der Gateelektrode (3) ist; und

einen dritten Verunreinigungsbereich (14), der mit einer Verunreinigung vom zum Leitfähigkeitstyp des Halbleitersubstrats (11) entgegengesetzten Leitfähigkeitstyp dotiert ist, welche Verunreinigung von dem dritten Verunreinigungsbereich einen Diffusionskoeffizienten hat, der kleiner als derjenige der Verunreinigung des zweiten Verunreinigungsbereichs ist, welcher dritte Verunreinigungsbereich (14) sich seitlich zu einem Bereich erstreckt, der mit seitlichem Abstand von dem genannten Rand des entsprechenden Source- oder Drainbereichs angeordnet ist und sich zu einer zweiten Tiefe erstreckt, die geringer als die genannte erste Tiefe des zweiten Verunreinigungsbereichs (15b) ist, welcher dritte Verunreinigungsbereich eine höhere Konzentration als diejenige der ersten und der zweiten Verunreinigungsbereiche hat.

2. Vorrichtung nach Anspruch 1, bei der die Verunreinigung in dem ersten Verunreinigungsbereich (15a) Arsen ist.

3. Vorrichtung nach Anspruch 1 oder 2, bei der die Verunreinigung in dem zweiten Verunreinigungsbereich (15b) Phosphor ist.

4. Vorrichtung nach einem der vorhergehenden Ansprüche, dadurch gekennzeichnet, daß die Verunreinigung in dem dritten Verunreinigungsbereich (14) Arsen ist.

5. Vorrichtung nach einem der vorhergehenden Ansprüche, dadurch gekennzeichnet, daß der Abstand von dem Rand der Gateelektrode (3) durch die Breite einer Seitenwand (10) längs der Gateelektrode bestimmt ist.

6. Verfahren zur Herstellung einer Halbleitervorrichtung mit einer Gateelektrode (3), die auf einem Halbleitersubstrat (11) gebildet ist, und Source-(S)- und Drain-(D)-Bereichen, die in dem Halbleitersubstrat (11) gebildet sind, mit:

Dotieren jedes der Source- oder Drainbereiche mit einer Verunreinigung von einem Leitfähigkeitstyp, der entgegengesetzt zu demjenigen des Halbleitersubstrats (11) ist, Bilden eines flachen ersten Verunreinigungsbereichs, der sich seitlich zu dem Rand der jeweiligen Source-(S)- oder Drain-(D)-Bereich neben einem Rand (A) von dem Gate erstreckt und eine erste Grenzfläche mit dem Halbleitersubstrat (11) hat;

Dotieren von jedem der Source- oder Drainbereiche mit einer Verunreinigung von einem Leitfähigkeitstyp, der entgegengesetzt zu demjenigen des Halbleitersubstrats (11) ist und einen Diffusionskoeffizienten hat, der größer als derjenige der Verunreinigungen des ersten Verunreinigungsbereichs ist, Bilden eines zweiten Verunreinigungsbereichs (15b) der sich unterhalb des ersten Verunreinigungsbereichs (15a) zu einer ersten Tiefe erstreckt, sich seitlich zu dem Rand des entsprechenden Source-(S)- oder Drain-(D)-Bereichs erstreckt und eine zweite Grenzfläche mit dem Halbleitersubstrat (11) an dem Rand von dem Source-(S)- oder Drain-(D)-Bereich hat, welche genannte zweite Grenzfläche im wesentlichen tangential zu der ersten Grenzfläche an dem Rand des jeweiligen Source-(S)- oder Drain-(D)-Bereichs ist; und

Dotieren jedes der Source-(S)- oder Drain-(D)-Bereiche mit Verunreinigungen von einem Leitfähigkeitstyp, der entgegengesetzt zu demjenigen des genannten Halbleitersubstrats (11) ist und einen Diffusionskoeffizienten hat, der kleiner als derjenige der Verunreinigung des zweiten Verunreinigungsbereichs (15b) ist, bei einer Konzentration, die höher als diejenige der ersten und zweiten Verunreinigungsbereiche (15a, 15b) ist, Bilden eines dritten Verunreinigungsbereichs (14), der sich seitlich zu einem Bereich erstreckt, der seitlich mit Abstand von dem genannten Rand des entsprechenden Source-(S)- oder Drain-(D)-Bereichs angeordnet ist und sich zu einer zweiten Tiefe erstreckt, die geringer als die genannte erste Tiefe des zweiten Verunreinigungsbereichs (15b) ist.

7. Verfahren nach Anspruch 6, bei dem bei dem Schritt der Bildung eines flachen ersten Verunreinigungsbereichs (15a) Arsenionen in das Halbleitersubstrat (11) zu einer Dosierung von $1 \times 10^{13}$ bis $1 \times 10^{15}$ cm$^{-2}$ dotiert werden, und bei einer Beschleunigungsenergie von 60 bis 120 KeV.

8. Verfahren nach Anspruch 6 oder 7, bei dem bei dem Schritt der Bildung des zweiten Verunreinigungsbereichs (15b) die Phosphorionen in das Halbleitersubstrat (11) zu einer Dosierung von $1 \times 10^{13}$ bis $1 \times 10^{15}$ cm$^{-2}$ und bei einer Beschleunigungsenergie von 60 bis 80 KeV dotiert werden.

9. Vorrichtung nach einem der Ansprüche 6 bis 8, bei der bei dem Schritt der Bildung des dritten Verunreinigungsbereichs (14) Arsenionen in das Halbleitersubstrat (11) zu einer Dosierung von $3 \times$

$10^{15}$ bis $5 \times 10^{15}$ cm$^{-2}$ und bei einer Beschleunigungsenergie von 60 bis 120 KeV dotiert werden.

**Revendications**

1. Un dispositif à semiconducteurs comportant une électrode de grille formée sur un substrat semiconducteur (11) et des régions de source (S) et de drain (D) formées dans le substrat semiconducteur (11), chacune des régions de source (S) et de drain (D) comprenant:

une première région d'impureté de faible profondeur (15a), dopée avec une impureté d'un type de conductivité opposé à celui du substrat semiconducteur (11), et s'étendant latéralement jusqu'au bord de la région de source (S) ou de drain (D) respective qui est adjacent à un bord (A) de l'électrode de grille, et ayant une première surface de jonction avec le substrat semiconducteur (11);

une seconde région d'impureté (15b) dopée avec une impureté d'un type de conductivité opposé à celui du substrat semiconducteur (11), l'impureté de la seconde région d'impureté ayant un coefficient de diffusion supérieur à celui de l'impureté de la première région d'impureté, cette seconde région d'impureté s'étendant au-dessous de la première région d'impureté (15a), jusqu'à une première profondeur, et s'étendant latéralement jusqu'au bord de la région de source (S) ou de drain (D) respective, la seconde région d'impureté (15b) ayant une seconde surface de jonction avec le substrat semiconducteur (11) au bord précité de la région de source (S) ou de drain (D), cette seconde surface de jonction étant pratiquement tangente à la première surface de jonction au bord de la région de source (S) ou de drain (D) respective qui est adjacent au bord de l'électrode de grille (3); et

une troisième région d'impureté (14) dopée avec une impureté du type de conductivité opposé à celui du substrat semiconducteur (11), l'impureté de la troisième région d'impureté ayant un coefficient de diffusion inférieur à celui de l'impureté de la seconde région d'impureté, la troisième région d'impureté (14) s'étendent latéralement jusqu'à une région espacée latéralement par rapport au bord précité de la région de source ou de drain respective, et s'étendant jusqu'à une seconde profondeur inférieure à la première profondeur de la seconde région d'impureté (15b), la troisième région d'impureté ayant une concentration plus élevée que celle des première et seconde régions d'impureté.

2. Un dispositif selon la revendication 1, dans lequel l'impureté que contient la première région d'impureté (15a) est de l'arsenic.

3. Un dispositif selon la revendication 1 ou 2, dans lequel l'impureté que contient la seconde région d'impureté (15b) est du phosphore.

4. Un dispositif selon l'une quelconque des revendications précédentes, caractérisé en ce que l'impureté que contient la troisième région d'impureté (14) est de l'arsenic.

5. Un dispositif selon l'une quelconque des revendications précédentes, caractérisé en ce que l'espacement par rapport au bord de l'électrode de grille (3) est déterminé par la largeur d'une paroi latérale (10) qui s'étend le long de l'électrode de grille.

6. Un procédé de fabrication d'un dispositif à semiconducteurs comportant une électrode de grille (3) formée sur un substrat semiconducteur (11) et des régions de source (S) et de drain (D) formées dans le substrat semiconducteur (11), comprenant les opérations suivantes:

on dope chacune des régions de source ou de drain avec une impureté d'un type de conductivité opposé à celui du substrat semiconducteur (11), pour former une première région d'impureté de faible profondeur, qui s'étend latéralement jusqu'au bord de la région de source (S) ou de drain (D) respective qui est adjacent à un bord (A) de la grille, et qui comporte une première surface de jonction avec le substrat semiconducteur (11);

on dope chacune des régions de source ou de drain avec une impureté d'un type de conductivité opposé à celui du substrat semiconducteur (11) et ayant un coefficient de diffusion supérieur à celui de l'impureté de la première région d'impureté, pour former une seconde région d'impureté (15b) qui s'étend au-dessous de la première région d'impureté (15a), jusqu'à une première profondeur, et qui s'étend latéralement jusqu'au bord de la région de source (S) ou de drain (D) respective, et qui présente une seconde surface de jonction avec le substrat semiconducteur (11) au bord de la région de source (S) ou de drain (D), cette seconde surface de jonction étant pratiquement tangente à la première surface de jonction au bord de la région de source (S) ou de drain (D) respective; et

on dope chacune des régions de source (S) ou de drain (D) avec une impureté d'un type de conductivité opposé à celui du substrat semiconducteur (11), et ayant un coefficient de diffusion inférieur à celui de l'impureté de la seconde région d'impureté (15b), avec une concentration plus élevée que celle des première et seconde régions d'impureté (15a, 15b), pour former une troisième région d'impureté (14) qui s'étend latéralement jusqu'à une région qui est espacée latéralement par rapport au bord de la région de source (S) ou de drain (D) respective, et qui s'étend jusqu'à une seconde profondeur inférieure à la première profondeur de la seconde région d'impureté (15b).

7. Un procédé selon la revendication 6, dans lequel dans l'opération de formation de la première région d'impureté de faible profondeur (15a), on dope le substrat semiconducteur (11) avec des ions arsenic jusuq'à une dose de $1 \times 10^{13}$ à $1 \times 10^{15}$ cm$^{-2}$, et avec une énergie d'accélération de 60 à 120 keV.

8. Un procédé selon la revendication 6 ou 7, dans lequel dans l'opération de formation de la seconde région d'impurité (15b), on dope le substrat semiconducteur (11) avec des ions phosphore jusqu'à une dose de $1 \times 10^{13}$ à $1 \times 10^{15}$ cm$^{-2}$ et avec une énergie d'accélération de 60 à 80 keV.

9. Un dispositif selon l'une quelconque des revendications 6 à 8, dans lequel dans l'opération de formation de la troisième région d'impureté (14), on dope le substrat semiconducteur (11) avec des ions arsenic jusqu'à une dose de $3 \times 10^{15}$ à $5 \times 10^{15}$ cm$^{-2}$ et avec une énergie d'accélération de 60 à 120 keV.

Fig. IA

Fig. IB

Fig. 2

EP 0 195 607 B1

Fig. 3

Fig. 4

# Fig. 5A

# Fig. 5B

Fig.6A

Fig.6B

Fig.6C

Fig.6D

*Fig. 7A*

*Fig. 7B*

*Fig. 7C*

*Fig. 7D*